# EUROPEAN PATENT SPECIFICATION

(11) **EP 4 556 728 B1**
(45) Date of publication and mention of the grant of the patent: **14.10.2026**
(21) Application number: 23922408.2
(22) Date of filing: 20.11.2023
(51) Int. Cl.: G06F 1/16, F16C 11/04, H04M 1/02, G09F 9/30, F16C 11/12

(54) **ROTATING SHAFT ASSEMBLY AND FOLDABLE DEVICE**
DREHWELLENANORDNUNG UND KLAPPBARE VORRICHTUNG
ENSEMBLE ARBRE ROTATIF ET DISPOSITIF PLIABLE

(30) Priority: 16.02.2023 CN 202310152803
(43) Date of publication of application: 21.05.2025
(73) Proprietor: Honor Device Co., Ltd., Shenzhen, Guangdong 518040 (CN)
(72) Inventor: LIU, Xiaodong, Shenzhen, Guangdong 518040 (CN); CHEN, Ruihao, Shenzhen, Guangdong 518040 (CN); DONG, Shaohong, Shenzhen, Guangdong 518040 (CN)
(74) Representative: MERH-IP Matias Erny Reichl Hoffmann Patentanwälte PartG mbB
(86) International application number: PCT/CN2023/132722
(87) International publication number: WO 2024/169292

(56) References cited:
- EP-A1- 4 155 863
- WO-A1-2020/173341
- WO-A1-2022/171050
- WO-A1-2022/262457
- CN-A- 111 692 196
- CN-A- 113 923 279
- CN-A- 114 338 859
- CN-A- 114 738 370
- CN-A- 115 217 838
- CN-U- 217 029 623
- KR-B1- 102 284 053
- US-B1- 9 848 502

## Description

### CROSS-REFERENCE TO RELATED APPLICATIONS

### TECHNICAL FIELD

This application relates to the field of hinge structures, and in particular, to a hinge assembly and a foldable device.

### BACKGROUND

A hinge mechanism is a connection structure for implementing relative folding or unfolding of adjacent bodies of a foldable device.

To support a flexible screen in changing to a desired shape, a door plate assembly is independently provided with a door plate swing arm in some known foldable devices, thereby controlling, by using the door plate swing arm, a motion trajectory and a rotation angle of the door plate assembly when being folded or unfolded.

However, this additionally increases a quantity of movable parts and requires to reserve relatively large space. In addition, an interference problem of more movable components needs to be considered, making a structure design and a motion trajectory design more complex.

CN217029623U discloses a flexible screen hinge structure comprising a base, two first curved portions of which are respectively pivotally connected to two hinge modules. Each hinge module comprises a rotating member, a support link, a housing link, and a synchronous link that includes an adapter.

### SUMMARY

This application provides a hinge assembly and a foldable device, to resolve a problem of a complex structure design and a complex motion trajectory design because a door plate swing arm needs to be independently disposed in a hinge structure in the conventional technologies.

According to a first aspect, an embodiment of this application provides a hinge assembly for a foldable device. The hinge assembly includes a base and a plurality of swing portions. The plurality of swing portions are distributed on two sides of the base. The swing portion includes:
a first swing arm, where one end of the first swing arm is rotatably connected to the base, and the other end of the first swing arm is provided with a pin portion and a first arc-shaped slot;
a connection block, where the connection block is provided with a strip slot, the pin portion cooperates with the strip slot and can slide along a length direction of the strip slot and rotate relative to the connection block in the strip slot, and the connection block is further provided with a second arc-shaped slot;
a second swing arm, where one end of the second swing arm is rotatably connected to the base, and the other end of the second swing arm slidably cooperates with the connection block; and
a movable member, where one end of the movable member slidably cooperates with the first arc-shaped slot, so that the movable member can rotate about a circle center of the first arc-shaped slot relative to the first swing arm; the other end of the movable member slidably cooperates with the second arc-shaped slot, so that the connection block can rotate about a circle center of the second arc-shaped slot relative to the movable member; and the movable member is further provided with a connection portion configured to connect to a door plate assembly.

The hinge assembly in this embodiment is used in a foldable device (such as a foldable mobile phone). During assembly, the door plate assembly configured to support the flexible screen of the foldable device is connected to the connection portion of the movable member.

When the foldable device is folded or unfolded, the first swing arm and the second swing arm are driven by using the connection block to be rotatably folded or unfolded relative to the base. In addition, the two ends of the movable member respectively slidably cooperate with the first arc-shaped slot and the second arc-shaped slot. Therefore, based on planar high-pair cooperation between the pin portion and the strip slot, the first swing arm and the movable member each can obtain a rotation angle different from that of the connection block, which facilitates a support angle design of the door plate assembly and/or a rotation range avoidance design of the first swing arm.

A side that is of the connection block and that is near the base is provided with a concave cut slot, there are two strip slots, and the two strip slots are respectively located on two side slot surfaces of the cut slot. There are two pin portions, the two pin portions are respectively located on two sides of the first swing arm, and the two pin portions are respectively inserted into the two strip slots.

In this implementation, the connection between the connection block and the first swing arm is more stable and has better force balance through cooperation of the strip slots on the two sides and the pin portions.

An edge line of the side that is of the connection block and that is near the base is a first edge, and an edge line of a side that is of the connection block and that is away from the base is a second edge. An extension axis of the pin portion is parallel to a rotation axis of the first swing arm relative to the base, and the pin portion is located between the first edge and the second edge.

In this implementation, the pin portions are disposed between the two edge lines of the connection block, so that a length of a motion chain can be reduced, and a total length of a part that is of an overall structure of the first swing arm and the connection block and that protrudes from the base can be reduced, thereby facilitating structural miniaturization.

The connection block has a cooperating portion located between the second edge and a slot bottom surface of the cut slot, and the second arc-shaped slot is provided on the cooperating portion. The movable member is provided with a second arc-shaped slider. The second arc-shaped slider is connected to an end that is of the connection portion and that is away from the base. The second arc-shaped slider slidably cooperates with the second arc-shaped slot.

In this implementation, a relative angle of the movable member relative to the movable member can be reliably implemented through cooperation between the second arc-shaped slider and the second arc-shaped slot, which facilitates obtaining of a required rotation angle between the movable member and the door plate assembly. In addition, the second arc-shaped slot is disposed on the cooperating portion at a disposing position, to fully use space on the connection block and implement a relatively short length of the motion chain that needs to be added for cooperation between the movable member and the connection block, thereby facilitating structural miniaturization.

The cooperating portion is provided with a groove concave in a thickness direction of the connection block. There are two second arc-shaped slots. The two second arc-shaped slots are respectively disposed on two side groove surfaces of the groove. There are two second arc-shaped sliders. The two second arc-shaped sliders are respectively connected to two sides of the end that is of the connection portion and that is away from the base. The connection portion is at least partially embedded in the groove. The two second arc-shaped sliders respectively slidably cooperate with the two second arc-shaped slots. The thickness direction of the connection block is a thickness direction of the foldable device.

In this implementation, the groove is disposed to accommodate the connection portion of the movable member, so that a structure is more compact. In addition, the second arc-shaped slots are respectively disposed on two sides of the groove to cooperate with two sides of the movable member, so that sliding cooperation between the movable member and the connection block is more reliable and has better force balance. The cooperation is not prone to being stuck.

In a possible implementation, an edge line of a side that is of the first swing arm and that is away from the base is a third edge. The first swing arm is provided with a notched groove recessed from a middle position of the third edge. There are two first arc-shaped slots. The two first arc-shaped slots are respectively provided on two side groove surfaces of the notched groove. The movable member includes two first arc-shaped sliders. The two first arc-shaped sliders are respectively connected to ends of two sides that are of the connection portion and that are near the base. The connection portion is at least partially embedded in the notched groove. The two first arc-shaped sliders respectively slidably cooperate with the two first arc-shaped slots.

In this implementation, the connection portion is accommodated in the notched groove, to properly use structural space and implement a compact structure, thereby facilitating a structural miniaturization design. The first arc-shaped slots on the two sides cooperate with the two first arc-shaped sliders of the movable member, so that sliding cooperation between the movable member and the first swing arm is more reliable and has better force balance. The cooperation is not prone to being stuck.

In a possible implementation, an opening of the notched groove is opposite to an opening of the groove, and the notched groove and the groove jointly form space for accommodating the connection portion.

In this implementation, structures cooperate compactly and occupy small space.

In a possible implementation, an end that is of the first swing arm and that is away from the base has two extended sections that are respectively located on two sides of the notched groove. Two pin portions respectively protrude from outer side surfaces of the two extended sections. At least one side slot surface of the cut slot is inclined outwards at an opening of the cut slot to form a guide slope that is configured to guide the pin portion to be clipped into the strip slot.

In this implementation, the extended sections are obtained by disposing the notched groove. With guidance of the guide slope, the pin portions on the first swing arm can be conveniently clipped into the strip slot through elastic deformation.

In a possible implementation, lugs protruding from surfaces of the connection block in a thickness direction are respectively disposed on the two side slot surfaces of the cut slot. The strip slots are provided on the lugs.

In this implementation, the lugs are disposed to facilitate formation of the strip slots, and an escape groove on the door plate corresponding to the lug also avoids interference with the lug.

In a possible implementation, the connection block is provided with a sliding slot, and the sliding slot is at a middle position in a thickness direction of the connection block. The second swing arm is slidably inserted into the sliding slot.

In this implementation, the sliding slot of the connection block and the second swing arm slidably cooperate in an insertive connection manner.

In a possible implementation, a positioning hole is provided on a side that is of the connection portion and that faces the door plate, and the positioning boss is positioned in and connected to a positioning hole of the door plate assembly, so that the door plate assembly is positioned in and connected to the movable member.

In this implementation, cooperation between the positioning boss and the positioning hole facilitates positioning, cooperation, and disposing of the door plate assembly.

In a possible implementation, arc-shaped sliding slots are respectively provided on the two sides of the base, first swing arms in the swing portions on the two sides of the base are respectively provided with arc-shaped sliding bolts slidably cooperating with the arc-shaped sliding slots, and the arc-shaped sliding bolts slidably cooperate with the arc-shaped sliding slots, so that the first swing arm can rotate around a central axis of the arc-shaped sliding slot.

In this implementation, rotatable cooperation between the base and the first swing arm can be reliably implemented by using the arc-shaped sliding slots of the base and the arc-shaped sliding bolts of the first swing arm. In addition, a small shaft member does not need to be used in the structure, and installation is convenient.

In a possible implementation, the hinge assembly includes two rotating shaft members. The two rotating shaft members are spaced and connected to the base in parallel. Central axes of the two rotating shaft members and central axes of the arc-shaped sliding slots are spaced in parallel. Second swing arms in the swing portions on the two sides of the base are rotatably connected to the base respectively by using the two rotating shaft members.

In this implementation, the second swing arm can rotatably cooperate with the base by using the rotating shaft member.

In a possible implementation, the rotating shaft member is rotatably connected to the base, and the second swing arm is fastened to the rotating shaft member, so that the second swing arm can drive the rotating shaft member to rotate relative to the base. The hinge assembly further includes a synchronization assembly. The synchronization assembly includes two intermediate gears and two side gears. The two side gears are respectively fixedly disposed on the two rotating shaft members. The two intermediate gears are respectively rotatably connected to the base and are respectively engaged with the two side gears. The two intermediate gears are engaged with each other. In this way, rotation of any one of the rotating shaft members can drive, by using the two intermediate gears, the other rotating shaft member to synchronously rotate.

In this implementation, synchronous rotation of the swing portions on the two sides can be conveniently implemented through rotatable installation of the rotating shaft members by using the side gears and the intermediate gears.

In a possible implementation, the second swing arm includes a plate portion and two sleeve portions. The two sleeve portions are spaced and connected to the plate portion. The plate portion slidably cooperates with the connection block. The two sleeve portions are separately sleeved on the rotating shaft member. The hinge assembly further includes a damping assembly. The damping assembly includes two damping springs and two damping blocks. The damping block is provided with two cooperating holes and is slidably sleeved on two rotating shaft members by using the two cooperating holes. The two damping blocks are spaced and located between the two sleeve portions. The damping springs are respectively supported between the two damping blocks and make the two damping blocks respectively elastically abut against the two sleeve portions. In this way, the sleeve portions cooperate with the damping blocks in a damping manner.

In this implementation, the second swing arm structure is fully used to cooperate with the damping springs and the damping blocks, so that a rotatable damping function can be conveniently implemented.

In a possible implementation, the strip slot is of an elongated circular shape, the pin portion is of a cylindrical shape, and two ends of the strip slot in a length direction are used as two motion limit positions of the pin portion.

In this implementation, relative sliding and rotation can be implemented for the elongated circular strip slot and the cylindrical pin portion.

In a possible implementation, the connection portion has a connection surface used to fit and support the door plate. The movable member includes a first arc-shaped slider and a second arc-shaped slider. The first arc-shaped slider and the second arc-shaped slider are separately connected to the connection portion in a side direction. The first arc-shaped slider slidably cooperates with the first arc-shaped slot. The second arc-shaped slider slidably cooperates with the second arc-shaped slot. In a process in which the hinge assembly changes from an unfolded state to a folded state, when the movable member rotates with the connection block relative to the base, the movable member rotates relative to the connection block toward a side of a midplane of the base through relative sliding of the first arc-shaped slider in the first arc-shaped slot and relative sliding of the second arc-shaped slider in the second arc-shaped slot, so that an overall rotation angle of the connection surface is greater than a rotation angle of the connection block.

In this implementation, the movable member implements relative rotation and cooperation with the first swing arm and the connection block by using the first arc-shaped slider and the second arc-shaped slider on the two sides, and is connected to the door plate by using the connection portion. This has a reasonable structure and facilitates a support angle design of the door plate assembly.

According to a first example that is not encompassed by the claims but useful for understanding the invention, the first example provides a hinge assembly, used in a foldable device. The hinge assembly includes a base and a plurality of swing portions. The plurality of swing portions are distributed on two sides of the base. The swing portion includes: a first swing arm, a movable member, a connection block, and a second swing arm. The first swing arm and the second swing arm are separately rotatably connected to the base. The movable member is connected between the first swing arm and the connection block. The movable member is rotatably connected to the first swing arm. The movable member is rotatably connected to the connection block. The second swing arm is slidably connected to the connection block. Planar high-pair cooperation with two degrees of freedom is formed between the first swing arm and the connection block. The movable member is further provided with a connection portion configured to connect to a door plate assembly. The door plate assembly is configured to support a flexible screen.

The hinge assembly in the first example is used in the foldable device (such as a foldable mobile phone). During assembly, the door plate assembly configured to support the flexible screen of the foldable device is connected to the connection portion of the movable member.

When the foldable device is folded or unfolded, the first swing arm and the second swing arm are driven by using the connection block to be rotatably folded or unfolded relative to the base. In addition, the two ends of the movable member respectively slidably cooperate with the first swing arm and the connection block. Therefore, based on planar high-pair cooperation between the swing arm and the connection block, the first swing arm and the movable member each can obtain a rotation angle different from that of the connection block, which facilitates a support angle design of the door plate assembly and/or a rotation range avoidance design of the first swing arm.

According to a second aspect, this application provides a foldable device. The foldable device includes:
the foregoing hinge assembly;
two bodies, where two bodies are respectively located on two sides of a base, and the two bodies are respectively connected to connection blocks of swing portions on the two sides;
a door plate assembly, where the door plate assembly is connected to movable members on the two sides of the base; and
a flexible screen, where the flexible screen covers the two bodies, the flexible screen has a bendable part, and the bendable part is supported on the door plate assembly.

The foregoing hinge assembly is used in the foldable device in this embodiment. The flexible screen of the foldable device can obtain reliable support of the hinge assembly and the door plate assembly.

In a possible implementation, the door plate assembly includes two door plates, and two door plates are respectively connected to the movable members on the two sides of the base.

In this implementation, the door plate assembly of this structure is installed conveniently, and can reliably support the flexible screen.

In a possible implementation, the door plate assembly includes a flexible support plate, and the flexible support plate is bridged between the movable members on the two sides of the base.

In this implementation, the door plate assembly has a larger support area for the flexible screen.

In a possible implementation, the flexible support plate is made of an elastic material; or
the flexible support plate includes an intermediate plate region and side plate regions respectively connected to two sides of the intermediate plate region, the two side plate regions are respectively connected to the movable members on the two sides of the base, and the intermediate plate region is disposed in a hollow shape or with a reduced thickness, so that the intermediate plate region can be bent and deformed under force.

In this implementation, the door plate assembly has a larger support area for the flexible screen, and has better flexibility.

### BRIEF DESCRIPTION OF DRAWINGS

To describe the technical solutions of embodiments of this application more clearly, the following briefly describes the accompanying drawings of embodiments. It should be understood that the following accompanying drawings show only some embodiments of this application, which cannot be considered as limitation on the scope. A person of ordinary skill in the art may still derive other accompanying drawings from the accompanying drawings without creative efforts.
FIG. 1 is a schematic diagram of a structure of a foldable device according to an embodiment of this application;
FIG. 2 is a schematic diagram of a structure of the foldable device in FIG. 1 in a folded state;
FIG. 3 is a schematic diagram of a structure of the foldable device in FIG. 1 in an unfolded state;
FIG. 4 is a sectional view of a foldable device in an unfolded state according to an embodiment of this application;
FIG. 5 is a sectional view of the foldable device in FIG. 4 in a folded state;
FIG. 6 is a schematic diagram of a structure of a hinge assembly according to an embodiment of this application;
FIG. 7 is a schematic diagram of a structure of cooperation between the hinge assembly in FIG. 6 and a door plate assembly;
FIG. 8 is an exploded view of the hinge assembly and the door plate assembly in FIG. 7;
FIG. 9 is a cross-sectional view of the hinge assembly and the door plate assembly in FIG. 7 along an A-A line;
FIG. 10 is a schematic diagram of the hinge assembly and the door plate assembly in FIG. 9 in a folded state;
FIG. 11 is a cross-sectional view of the hinge assembly and the door plate assembly in FIG. 7 along a B-B line;
FIG. 12 is a schematic diagram of the hinge assembly and the door plate assembly in FIG. 11 in a folded state;
FIG. 13 is a cross-sectional view of the hinge assembly and the door plate assembly in FIG. 7 along a C-C line;
FIG. 14 is a schematic diagram of the hinge assembly and the door plate assembly in FIG. 13 in a folded state;
FIG. 15 is a cross-sectional view of the hinge assembly and the door plate assembly in FIG. 7 along a D-D line;
FIG. 16 is a schematic diagram of the hinge assembly and the door plate assembly in FIG. 15 in a folded state;
FIG. 17 is a schematic diagram of a structure of cooperation between a hinge assembly and a door plate assembly according to another embodiment of this application;
FIG. 18 is an exploded view of the hinge assembly and the door plate assembly in FIG. 17;
FIG. 19 is a schematic diagram of a structure of cooperation between a hinge assembly and another door plate assembly according to this application; and
FIG. 20 is a schematic diagram of a structure of cooperation between a hinge assembly and still another door plate assembly according to this application.

### Reference numerals of main elements:

| | |
|---|---|
| Foldable device | 100 |
| Flexible screen | 110 |
| Bendable part | 111 |
| Body | 130 |
| First body | 130a |
| Second body | 130b |
| Door plate assembly | 150, 150a, 150b |
| Door plate | 151 |
| Hinge assembly | 10, 80 |
| Base | 11 |
| Swing portion | 12 |
| First swing arm | 13 |
| Connection block | 14 |
| Second swing arm | 15, 15a |
| Movable member | 16 |
| Pin portion | 17 |
| Connection portion | 18 |
| Arc-shaped sliding bolt | 19 |
| First arc-shaped slider | 20 |
| Cooperating portion | 21 |
| Extended section | 22 |
| Rotating shaft member | 23, 23a |
| Positioning hole | 24 |
| Positioning boss | 25 |
| Damping assembly | 26 |
| Synchronization assembly | 27 |
| Second arc-shaped slider | 28 |
| Intermediate gear | 29 |
| Side gear | 30 |
| Plate portion | 31 |
| Sleeve portion | 32 |
| Damping spring | 33 |
| Damping block | 34 |
| Flexible support plate | 35 |
| Intermediate plate region | 36 |
| Side plate region | 37 |
| Lug | 38 |
| First edge | L1 |
| Second edge | L2 |
| Third edge | L3 |
| First arc-shaped slot | C1 |
| Second arc-shaped slot | C2 |
| Strip slot | C3 |
| Arc-shaped sliding slot | C4 |
| Notched groove | C5 |
| Sliding slot | C6 |
| Cut slot | C7 |
| Groove | C8 |
| Escape groove | C9 |
| Connection surface | P1 |
| Midplane | P2 |
| Guide slope | P3 |
| Cooperating hole | K1 |
| Width direction | Y1 |
| Length direction | Y2 |

### DESCRIPTION OF EMBODIMENTS

The following clearly and completely describes the technical solutions in embodiments of this application with reference to the accompanying drawings in embodiments of this application. Apparently, the described embodiments are merely some but not all of embodiments of this application.

It should be noted that, when an element is referred to as "being fastened to" another element, the element may be directly on the another element, or there may be an element in between. When a component is deemed as being "connected to" another component, it may be directly connected to the another component, or there may be a component in between. When a component is deemed as being "provided on" another component, it may be directly provided on the another component, or there may be a component in between. The terms "vertical", "horizontal", "left", "right", and other similar expressions as used herein are for illustration only.

Unless otherwise defined, meanings of all technical and scientific terms used in this specification are the same as those usually understood by a person skilled in the art to which this application belongs. In this specification, terms used in the specification of this application are merely intended to describe objectives of the specific implementations, but are not intended to limit this application. The term "and/or" used herein includes any and all combinations of one or more related listed items.

Some implementations of this application are described below in detail. In absence of conflicts, the following embodiments and features in the embodiments may be combined.

A foldable device such as a foldable mobile phone or a foldable tablet computer usually includes two or more bodies. Adjacent bodies are connected to each other by using a hinge assembly, to implement folding or unfolding of the bodies.

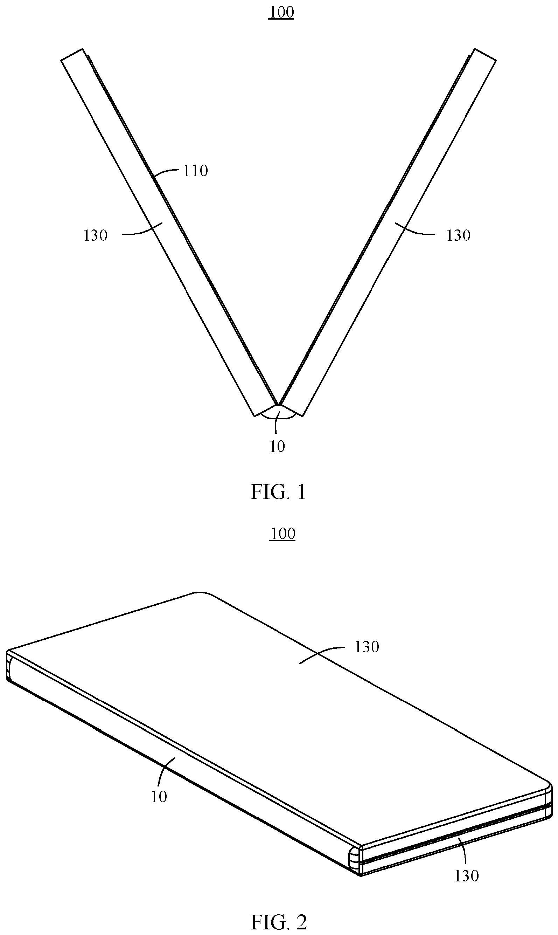

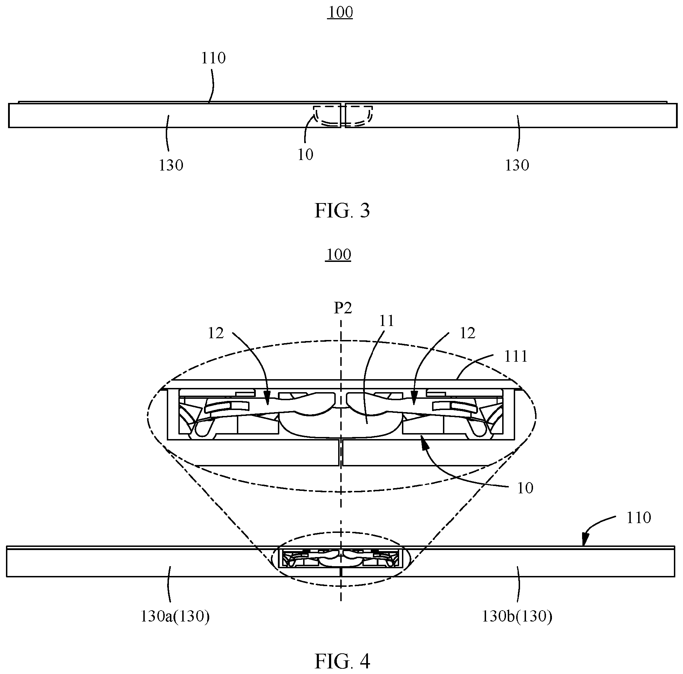

For example, FIG. 1 shows a foldable device 100 including a flexible screen 110, a hinge assembly 10, and two bodies 130. For ease of description, the two bodies 130 are respectively named as a first body 130a and a second body 130b. The first body 130a and the second body 130b are connected by using the hinge assembly 10, and can be folded or unfolded by using the hinge assembly 10, so that the foldable device 100 is in a folded state shown in FIG. 2 or in an unfolded state shown in FIG. 3. Certainly, in some special cases, the foldable device 100 may also be used in an incomplete unfolded state shown in FIG. 1.

It should be noted that FIG. 1 to FIG. 3 merely simply show positions and connection relationships of the first body 130a, the second body 130b, and the hinge assembly 10. A specific shape of the first body 130a, the second body 130b, and the hinge assembly 10 are not limited.

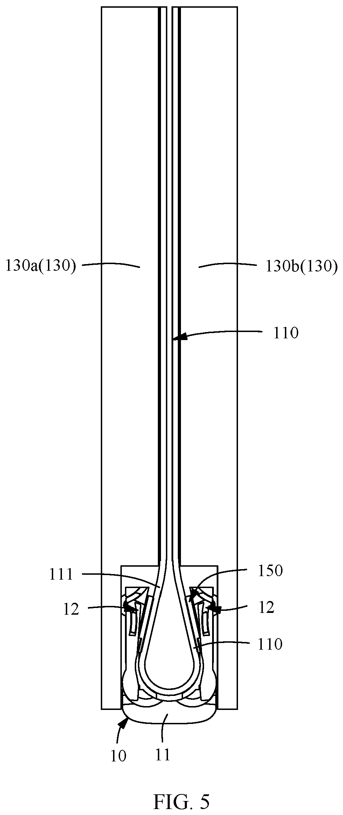

With reference to FIG. 4 and FIG. 5, the flexible screen 110 covers the first body 130a and the second body 130b. The flexible screen 110 has a bendable part 111 that can be adaptably bent when the first body 130a and the second body 130b are folded relative to each other, for example, bent into a U shape or a water drop shape. Refer to FIG. 5 for a state of bending into the water drop shape. The flexible screen 110 shown in the figure is located inside the foldable device 100. In other words, after being folded, the flexible screen 110 is protected between the first body 130a and the second body 130b.

The foldable device 100 in this embodiment further includes a door plate assembly 150. The door plate assembly 150 is configured to support the flexible screen 110. In this embodiment, the door plate assembly 150 is connected to the hinge assembly 10, and can support the flexible screen 110 in an unfolded state when the foldable device 100 is unfolded (with reference to FIG. 5) and support the flexible screen 110 in a folded state when the foldable device 100 is folded (with reference to FIG. 4).

As shown in FIG. 4 and FIG. 5, in some cases, to support the flexible screen 110 of a desired shape (for example, a water drop shape, a U shape, or another shape), the door plate assembly 150 needs to have a rotation angle adapted to a bent shape of the flexible screen 110 when the foldable device 100 changes from unfolded to folded.

In addition, in some support cases of the flexible screen 110, the rotation angle of the door plate assembly 150 may be inconsistent with a rotation angle of the bodies 130 during folding. For example, in the water drop shape support manner of the flexible screen 110 shown in FIG. 4 and FIG. 5, the rotation angle of the first body 130a/the second body 130b is 90°, and the rotation angle of the door plate assembly 150 is greater than 90°.

To implement a design requirement of inconsistent rotation angles of the door plate assembly and the bodies, the door plate assembly is independently provided with a door plate swing arm in some other known foldable devices, thereby controlling, by using the door plate swing arm, a motion trajectory and a rotation angle of the door plate assembly 150 when being folded or unfolded. However, this additionally increases a quantity of movable parts and requires to reserve relatively large space. In addition, an interference problem of more movable components needs to be considered, making a structure design and a motion trajectory design more complex.

The hinge assembly 10 or 80 provided in embodiments can be well adapted to a case in which the rotation angle of the door plate assembly 150 is inconsistent with the folding rotation angle of the bodies 130, and no additional door plate swing arm needs to be added. The following provides descriptions in detail.

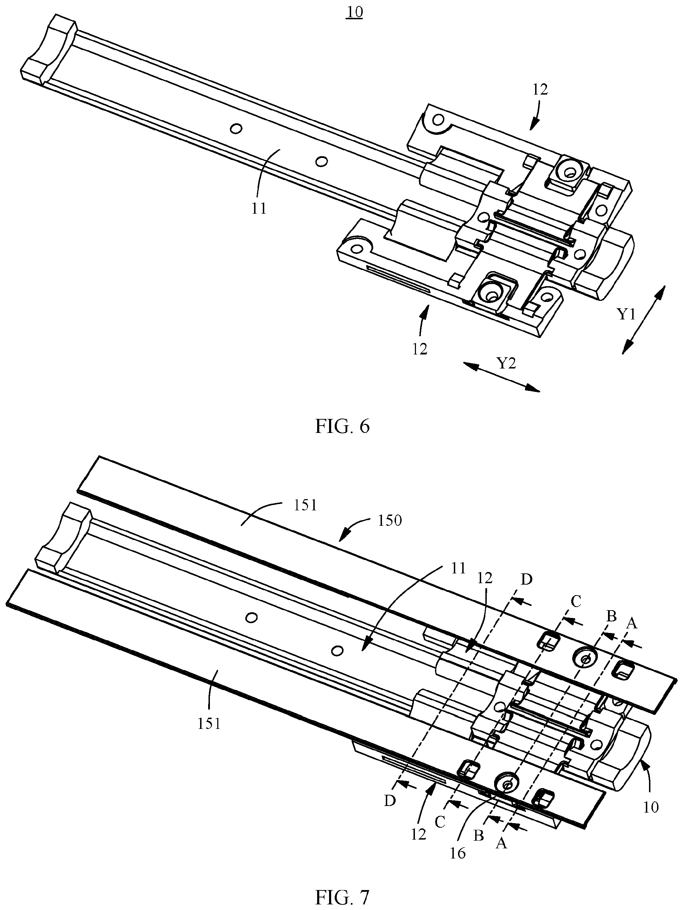

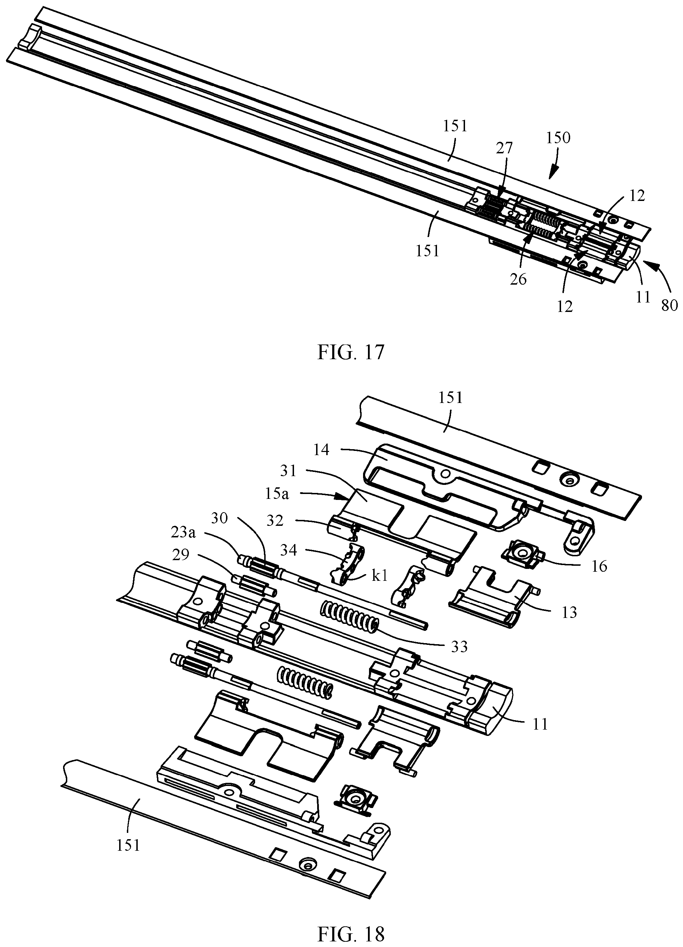

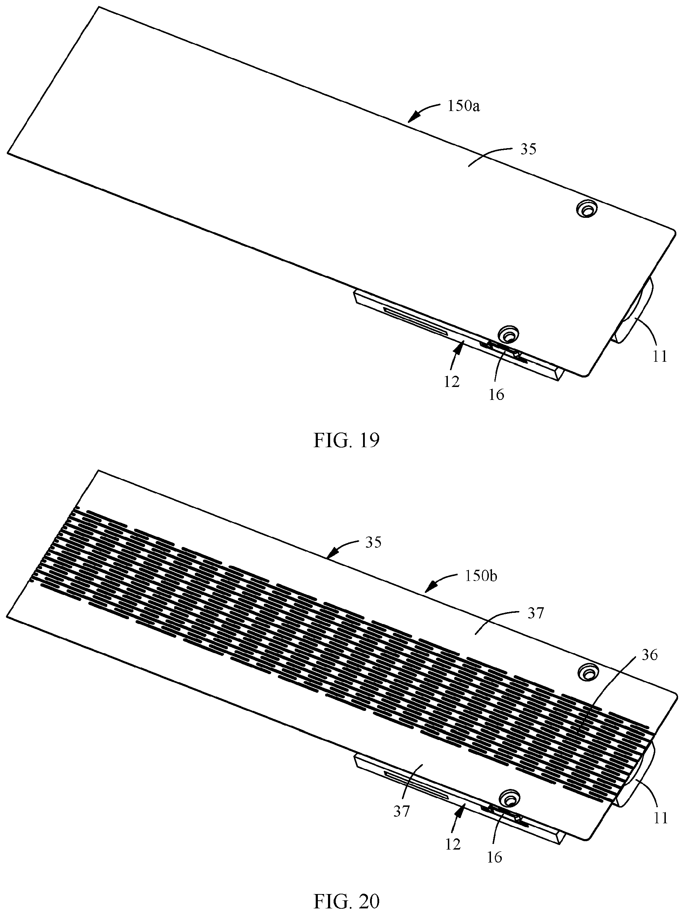

FIG. 6 to FIG. 16 each show a hinge assembly 10 according to an embodiment of this application. FIG. 17 and FIG. 18 each show a hinge assembly 80 according to another embodiment of this application. FIG. 19 and FIG. 20 respectively show door plate assemblies 150a and 150b different from the door plate assembly 150.

With reference to FIG. 6, the hinge assembly 10 includes a base 11 and a plurality of swing portions 12. The plurality of swing portions 12 are distributed on two sides of the base 11. A first body 130a and a second body 130b are respectively located on two sides of the base 11, and are respectively connected to the swing portions 12 on the two sides (with reference to FIG. 4 or FIG. 5).

As shown in FIG. 6, the base 11 is approximately in a long strip shape, and the swing portions 12 are symmetrically distributed and disposed on the two sides of the base 11 in a width direction Y1. It should be noted that only one swing portion 12 on each side is shown in FIG. 6. In actual use, a quantity of swing portions 12 on each side may be set to two, three, or more as required. The swing portions 12 on the two sides may be in a symmetrical form shown in FIG. 6, or may be in a staggered form in a length direction Y2 of the base 11. This is not limited herein.

In another embodiment of this application, a shape and a structure of the base 11 may also be set as required. For example, the base 11 is disposed in a whole strip shape, or disposed as a plurality of segments in an extension direction to separately connect a plurality of groups of swing portions 12. Alternatively, the base 11 includes a long strip-shaped bottom housing and a plurality of relatively short base blocks disposed in the bottom housing, and the plurality of base blocks are configured to mount the plurality of swing portions 12. The base blocks may be fastened to or movably connected to the bottom housing to adapt to different requirements.

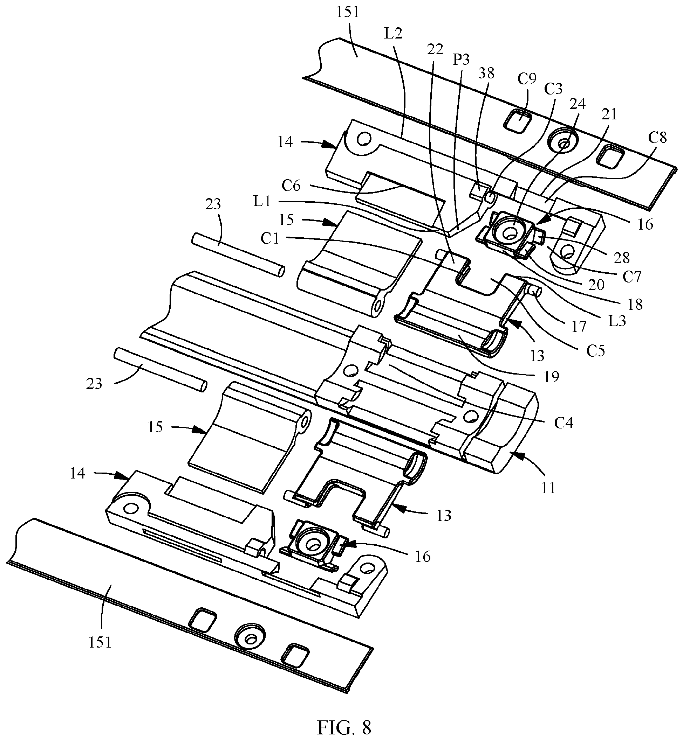

With reference to FIG. 7 and FIG. 8, in this embodiment, the swing portion 12 includes a first swing arm 13, a connection block 14, a second swing arm 15, and a movable member 16. The first swing arm 13 and the second swing arm 15 are separately rotatably connected to the base 11 to form a movable mechanism including the base 11, the first swing arm 13, the connection block 14, the second swing arm 15, and the movable member 16. Planar low-pair cooperation with one degree of freedom is separately formed between the base 11 and the first swing arm 13, between the first swing arm 13 and the movable member 16, between the movable member 16 and the connection block 14, between the connection block 14 and the second swing arm 15, and between the second swing arm 15 and the base 11. Planar high-pair cooperation with two degrees of freedom is additionally formed between the first swing arm 13 and the connection block 14. Calculation is performed by using the base 11 as a fixed component. There are four movable components (the first swing arm 13, the connection block 14, the second swing arm 15, and the movable member 16) in the movable mechanism. There are five planar low pair with one degree of freedom, and one planar high pair with two degrees of freedom. According to a formula for calculating a degree of freedom, a degree of freedom of the movable mechanism is 3 * 4 - 2 * 5 - 1 = 1. In other words, the movable mechanism can implement uniqueness and reliability of a motion trajectory of each movable component.

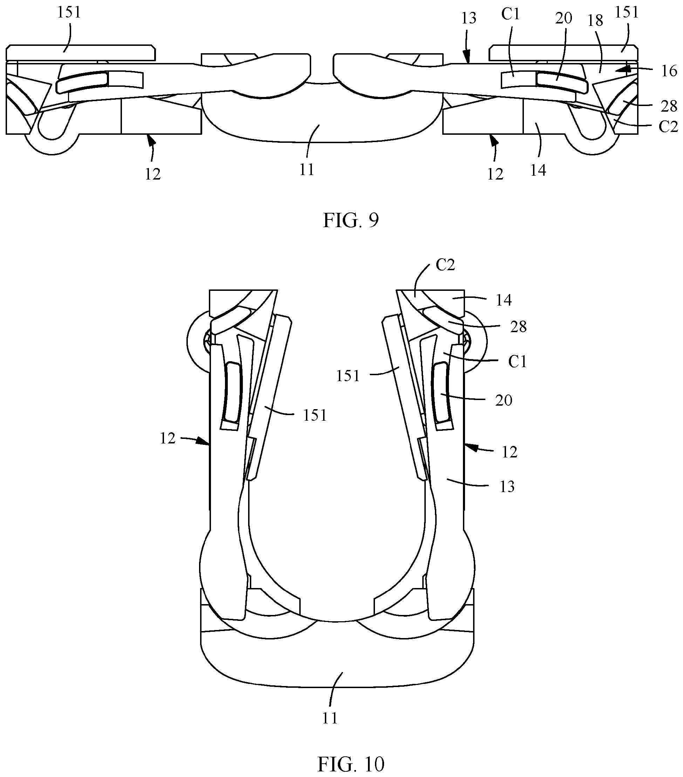

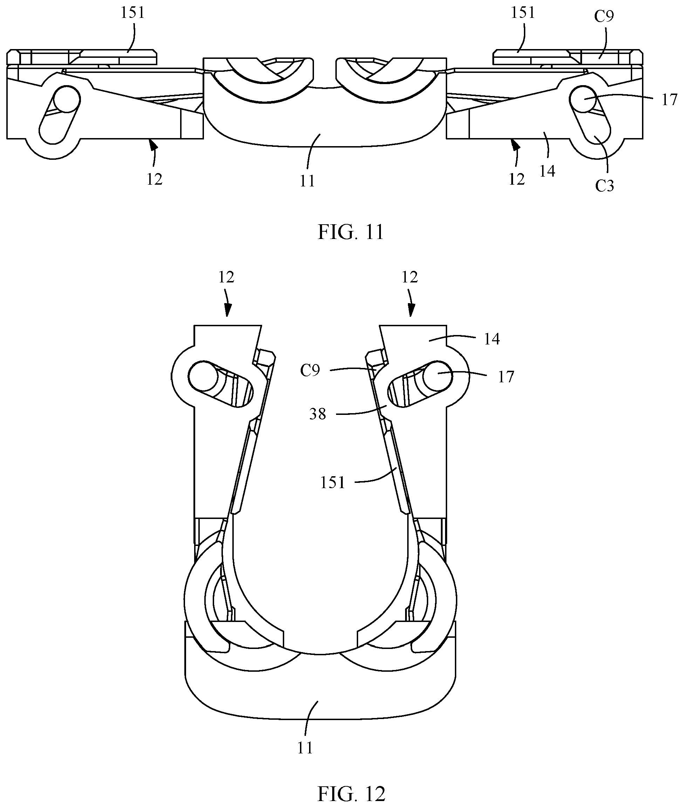

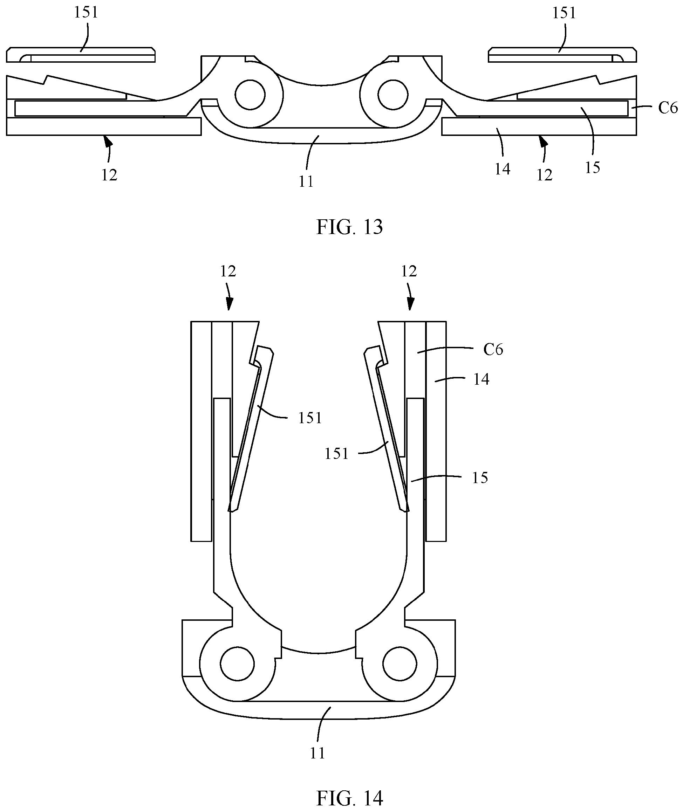

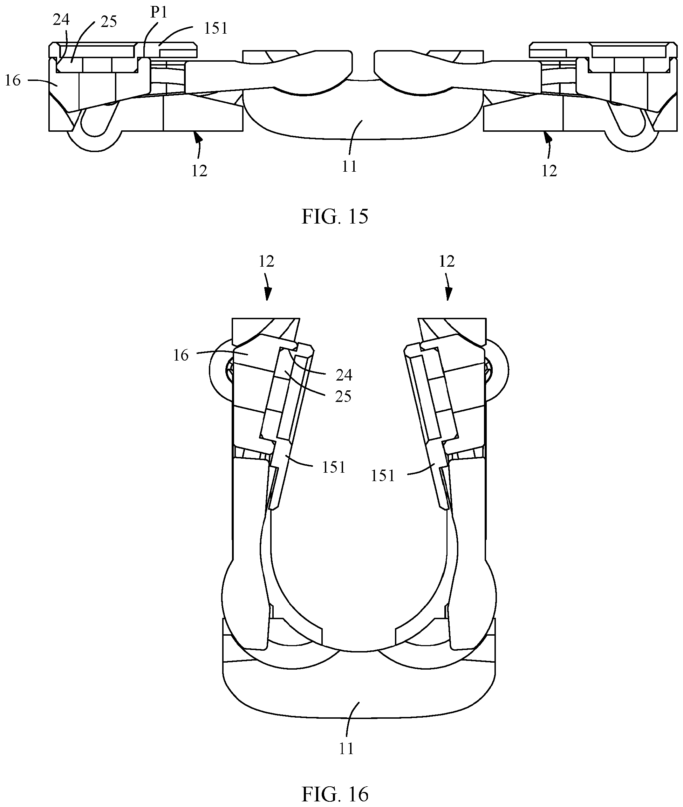

With reference to FIG. 8, in this embodiment, one end of the first swing arm 13 is rotatably connected to the base 11, and the other end of the first swing arm 13 is provided with a pin portion 17 and a first arc-shaped slot C1 (with reference to FIG. 9 or FIG. 10). The connection block 14 is provided with a strip slot C3 (with reference to FIG. 11 or FIG. 12). The pin portion 17 cooperates with the strip slot C3 and can slide along a length direction of the strip slot C3 and rotate relative to the connection block 14 in the strip slot C3. The connection block 14 is further provided with a second arc-shaped slot C2 (with reference to FIG. 9 or FIG. 10). One end of the second swing arm 15 is rotatably connected to the base 11, and the other end of the second swing arm 15 slidably cooperates with the connection block 14 (with reference to FIG. 13 or FIG. 14). One end of the movable member 16 slidably cooperates with the first arc-shaped slot C1, so that the movable member 16 can rotate about a circle center of the first arc-shaped slot C1 relative to the first swing arm 13. The other end of the movable member 16 slidably cooperates with the second arc-shaped slot C2, so that the connection block 14 can rotate about a circle center of the second arc-shaped slot C2 relative to the movable member 16. The movable member 16 is further provided with a connection portion 18 configured to connect to a door plate assembly 150 (with reference to FIG. 15 or FIG. 16). The door plate assembly 150 is configured to support a flexible screen 110. Optionally, the door plate assembly 150 includes two door plates 151, and two door plates 151 are respectively connected to the connection blocks 14 of the swing portions 12 on the two sides of the base 11.

When the foldable device 100 is folded or unfolded, the bodies 130 (the first body 130a and/or the second body 130b) of the foldable device 100 drive the first swing arm 13 and the second swing arm 15 by using the connection block 14 to be rotatably folded or unfolded relative to the base 11. In addition, the two ends of the movable member 16 respectively slidably cooperate with the first arc-shaped slot C1 and the second arc-shaped slot C2. Therefore, based on planar high-pair cooperation between the pin portion 17 and the strip slot C3, the movable member 16 can obtain a rotation angle different from that of the connection block 14, which facilitates a support angle design of the door plate assembly 150 connected to the movable member 16.

In addition, the first swing arm 13 and the connection block 14 movably cooperate by using the movable member 16. Therefore, a rotation angle of the first swing arm 13 may be set to different from that of the connection block 14. In this way, a relatively small rotation angle may be designed for the first swing arm 13, to avoid a problem in which the first swing arm 13 and the flexible screen 110 interfere with each other in the folded state due to an excessively large rotation angle of the first swing arm 13. In another aspect, due to a relatively small angle rotation of the first swing arm 13, cooperation structures with only relatively small arcs (for example, an arc-shaped sliding bolt 19 of the first swing arm 13 and an arc-shaped sliding slot C4 of the base 11) need to be maintained on the first swing arm 13 and the base 11, to meet rotatable cooperation of the first swing arm 13, which facilitates a design of the base 11 with a relatively small width and facilitates a thin design of the foldable device 100. In addition, in the folded state, the first swing arm 13 with a relatively small arc requirement is also less prone to protrusion in the width direction of the base 11 or protrusion by a small distance, and has small impact on a thickness of the foldable device 100, which facilitates miniaturization of a thickness of the hinge assembly 10.

In addition, high-pair cooperation is formed between the first swing arm 13 and the connection block 14 (cooperation between the strip slot C3 and the pin portion 17), and a length of a tolerance chain of motion cooperation among the first swing arm 13 - the movable member 16 -the connection block 14 is reduced, thereby reducing processing difficulty and more easily ensuring accurate motion cooperation.

In this embodiment, still with reference to FIG. 4 and FIG. 5, the two bodies 130 (the first body 130a and the second body 130b) of the foldable device 100 are respectively located on the two sides of the base 11, and the two bodies 130 are respectively connected to the connection blocks 14 of the swing portions 12 on the two sides. A connection between the body 130 and the connection block 14 may be a direct fixed connection, or may be an indirect fixed connection implemented by using an intermediate structure (for example, a pad). In this way, when a user needs to fold or unfold the foldable device 100, force applied to any body 130 causes the body 130 and the connection block 14 to rotate together by a specified angle. For example, between the states shown in FIG. 4 and FIG. 5, rotation angles of the body 130 and the connection block 14 are 90°. This is not limited. The rotation drives the entire swing portion 12 to move relative to the base 11. In addition, sliding along the arc-shaped slots (the first arc-shaped slot C1/the second arc-shaped slot C2) exists between the connection block 14 and the movable member 16, and between the movable member 16 and the first swing arm 13. Therefore, the first swing arm 13 and the movable member 16 rotate by a specific angle relative to the connection block 14 when rotating with the connection block 14, thereby obtaining rotation angles different from that of the connection block 14.

For example, to support a water drop shape of the flexible screen 110, the rotation angle of the movable member 16 is greater than 90° of rotation of the body 130 and the connection block 14. In other words, in a process from unfolding to folding, the movable member 16 deflects by an angle relative to the connection block 14 toward a midplane P2 of the base 11, so that the door plate 151 connected to the movable member 16 rotates by more than 90°. Therefore, two half screens of the flexible screen 110 include sections between which distances gradually decrease on a side away from the base 11, thereby presenting a water drop shape. The midplane P2 of the base 11 herein means a plane of symmetry at a middle position in the width direction of the base 11. The movable member 16 is slidably disposed relative to the first swing arm 13 and the connection block 14, to provide optimization space for rotatable cooperation between the first swing arm 13 and the base 11 at a central axis position of the shaft. This also facilitates better fitting of the first swing arm 13 to the water drop shape of the flexible screen 110 in the folded state, so that rotation centers of the first swing arms 13 on the two sides can be closer. In addition, the base 11 with a smaller width can be designed, and an overall size of the hinge assembly 10 is reduced, thereby facilitating a thin design of the foldable device 100.

With reference to FIG. 8 and FIG. 10, arc-shaped sliding slots C4 are respectively provided on the two sides of the base 11, the first swing arms 13 in the swing portions 12 on the two sides of the base 11 are respectively provided with arc-shaped sliding bolts 19 slidably cooperating with the arc-shaped sliding slots C4, and the arc-shaped sliding bolts 19 slidably cooperate with the arc-shaped sliding slots C4, so that the first swing arm 13 can rotate around a central axis of the arc-shaped sliding slot C4, to implement a rotatable connection between the first swing arm 13 and the base 11. Certainly, in another embodiment, a rotable connection may be alternatively formed between the first swing arm 13 and the base 11 in another manner. This is not limited herein.

An edge line of a side that is of the first swing arm 13 and that is away from the base 11 is a third edge L3. The first swing arm 13 is provided with a notched groove C5 recessed from a middle position of the third edge L3. There are two first arc-shaped slots C1. The two first arc-shaped slots C1 are respectively provided on two side groove surfaces of the notched groove C5. The movable member 16 includes two first arc-shaped sliders 20. The two first arc-shaped sliders 20 are respectively connected to ends of two sides that are of the connection portion 18 and that are near the base 11. The connection portion 18 is at least partially embedded in the notched groove C5. The two first arc-shaped sliders 20 respectively slidably cooperate with the two first arc-shaped slots C1. In this way, the notched groove C5 is disposed to accommodate the connection portion 18, to form cooperation of two groups of the first arc-shaped sliders 20 and the first arc-shaped slots C1. In addition to fully space utilization, this facilitates stable sliding cooperation between the movable member 16 and the first swing arm 13. Certainly, in another embodiment, a relative rotable connection may be alternatively formed between the movable member 16 and the first swing arm 13 in another manner, for example, a pin joint implemented by using a shaft entity. This is not limited herein.

Still with reference to FIG. 8 and FIG. 10, an edge line of the side that is of the connection block 14 and that is near the base 11 is a first edge L1, and an edge line of a side that is of the connection block 14 and that is away from the base 11 is a second edge L2. The side that is of the connection block 14 and that is near the base 11 is provided with a concave cut slot C7. To be specific, the cut slot C7 is recessed from the first edge L1. The cut slot C7 does not penetrate to the second edge L2, so that an entity part corresponding to the cut slot C7 is maintained at the connection block 14, that is, a cooperating portion 21 between the second edge L2 and a slot bottom surface of the cut slot C7. The second arc-shaped slot C2 is provided on the cooperating portion 21. The movable member 16 is provided with a second arc-shaped slider 28. The second arc-shaped slider 28 is connected to an end that is of the connection portion 18 and that is away from the base 11. The second arc-shaped slider 28 slidably cooperates with the second arc-shaped slot C2. Certainly, in another embodiment, a relative rotable connection may be alternatively formed between the Connection block 14 and the movable member 16 in another manner, for example, a pin joint implemented by using a shaft entity. This is not limited herein.

Optionally, the cooperating portion 21 is provided with a groove C8 concave in a thickness direction of the connection block 14, and the groove C8 does not penetrate to a bottom surface of the cooperating portion 21. There are two second arc-shaped slots C2. The two second arc-shaped slots C2 are respectively disposed on two side groove surfaces of the groove C8. There are two second arc-shaped sliders 28. The two second arc-shaped sliders 28 are respectively connected to two sides of the end that is of the connection portion 18 and that is away from the base 11. The connection portion 18 is at least partially embedded in the groove C8. The two second arc-shaped sliders 28 respectively slidably cooperate with the two second arc-shaped slots C2.

In this embodiment, the movable member 16 is disposed, and the two ends of the movable member 16 are separately slidably fitted between each of the first arc-shaped slots C1 and each of the second arc-shaped slots C2, so that motion of the connection block 14 is not transmitted to the first swing arm 13 at an equal angle. In addition, the movable member 16 whose rotation angle can be relatively independently designed is added, to facilitate a connection to the door plate assembly 150. This facilitates an independent design of a rotation trajectory or a rotation angle of the door plate assembly 150. In addition, the notched groove C5 of the first swing arm 13, the cut slot C7 of the connection block 14, and the groove C8 are disposed to accommodate the movable member 16, thereby reducing an overall length of a connection chain of the first swing arm 13, the movable member 16, and the connection block 14 and a size in an overall thickness direction of the structure and fully using space. This facilitates a structural miniaturization design.

In this embodiment, optionally, the connection portion 18 of the movable member 16 is approximately a flat square block, and a top surface of the connection portion 18 is used as a connection surface P1, to fit and support the door plate 151. The two first arc-shaped sliders 20 and the two second arc-shaped sliders 28 are separately connected to two side surfaces of the connection portion 18. An opening of the notched groove C5 is opposite to an opening of the groove C8, the notched groove C5 and the groove C8 jointly form space for accommodating the connection portion 18. The first arc-shaped slider 20 and the second arc-shaped slider 28 of the movable member 16 slidably cooperate with the first arc-shaped slot C1 and the second arc-shaped slot C2. In a process in which the hinge assembly 10 changes from the unfolded state to the folded state, when the movable member 16 rotates with the connection block 14 relative to the base 11, the movable member 16 rotates relative to the connection block 14 toward a side of the midplane P2 of the base 11 through relative sliding of the first arc-shaped slider 20 in the first arc-shaped slot C1 and relative sliding of the second arc-shaped slider 28 in the second arc-shaped slot C2, so that an overall rotation angle of the connection surface P1 is greater than a rotation angle of the connection block 14.

In this embodiment, there are two strip slots C3, and the two strip slots C3 are respectively located on two side slot surfaces of the cut slot C7. Optionally, lugs 38 protruding from surfaces of the connection block in the thickness direction are respectively disposed on the two side slot surfaces of the cut slot C7. The strip slots C3 are provided on the lugs 38. An escape groove C9 corresponding to the lug 38 is provided at a position on the door plate 151. There are two pin portions 17, the two pin portions 17 are respectively located on two sides of the first swing arm 13, and the two pin portions 17 are respectively inserted into the two strip slots C3. An extension axis of the pin portion 17 is parallel to a rotation axis of the first swing arm 13 relative to the base 11, and the pin portion 17 is located between the first edge L1 and the second edge L2. Due to disposing of the notched groove C5, an end that is of the first swing arm 13 and that is away from the base 11 has two extended sections 22 that are respectively located on two sides of the notched groove C5, and the two pin portions 17 respectively protrude from outer side surfaces of the two extended sections 22. At least one side slot surface of the cut slot C7 is inclined outwards at an opening of the cut slot C7 to form a guide slope P3 that is configured to guide the pin portion 17 to be clipped into the strip slot C3. In this structure, due to disposing of the notched groove C5, the two extended sections 22 may be elastically deformed inwardly under pressure. With reference to disposing of the guide slope P3, it may be convenient for the pin portions 17 on the two sides to be clipped into the two strip slots C3. During specific installation, the pin portion 17 on one side may be clipped into the corresponding strip slot C3, and then the pin portion 17 on the other side slides inwardly along the guide slope P3. In a sliding process, the pin portion 17 and the extended section 22 on the side are elastically bent and deformed inwardly, and the elastic deformation of the extended section 22 is not released until the pin portion 17 corresponds to the strip slot C3, so that the pin portion 17 on the side is clipped into the strip slot C3, thereby completing installation of the two pin portions 17 to the two strip slots C3. Certainly, in another embodiment, for ease of installation, another form may also be used. For example, two removable parts may be disposed on the connection block 14 at the strip slot C3. In this way, the pin portion 17 may be installed first, and then the two removable parts are connected.

In this embodiment, optionally, the strip slot C3 is of an elongated circular shape, and the pin portion 17 is of a cylindrical shape. A basic size of a diameter of the pin portion 17 is equal to a width of the strip slot C3. The strip slot C3 is set to an elongated circular shape, and cooperates with the pin portion 17 of a cylindrical shape, to reliably implement relative sliding and relative rotation of the pin portion 17 in the strip slot C3. Optionally, two ends of the strip slot C3 in a length direction are used as two motion limit positions of the pin portion 17.

In another embodiment, positions of disposing the strip slot C3 and the pin portion 17 may be exchanged. To be specific, the strip slot C3 is disposed on the first swing arm 13, and the pin portion 17 is disposed on the connection block 14.

In the foregoing embodiment, the strip slot C3 and the pin portion 17 are used to form planar high-pair cooperation with two degrees of freedom between the first swing arm 13 and the connection block 14. The two degrees of freedom include a sliding degree of freedom and a rotation degree of freedom. In another embodiment, the planar high-pair coordination with the two degrees of freedom formed between the first swing arm 13 and the connection block 14 may also be in another form. For example, two sliding degrees of freedom are included. A specific implementation may be set according to a requirement. For example, long slots (extension directions of the two long slots incline to each other and intersect or are perpendicular to each other) are respectively disposed on the first swing arm 13 and the connection block 14, and cooperating sliders are disposed to respectively slidably cooperate with the long slot on the first swing arm 13 and the long slot on the connection block 14. Cooperation of the cooperating sliders and the two long slots is non-ratable.

As described above, sliding cooperation is formed between the second swing arm 15 and the connection block 14. In this embodiment, a sliding cooperation structure of the second swing arm 15 and the connection block 14 may be set according to a requirement.

For example, as shown in FIG. 8 and FIG. 14, the connection block 14 is provided with a sliding slot C6, and the sliding slot C6 is at a middle position in the thickness direction of the connection block 14. The second swing arm 15 is slidably inserted into the sliding slot C6. Optionally, the sliding slot C6 may be rectangular, T-shaped, strip-shaped, cylindrical hole-shaped, or the like. This is not limited herein.

In another embodiment, the sliding slot C6 may be alternatively disposed on the second swing arm 15, and the connection block 14 is provided with a sliding part that slidably cooperates with the sliding slot C6 on the second swing arm 15.

In another embodiment, the sliding cooperation between the second swing arm 15 and the connection block 14 may be indirectly implemented by using an additionally disposed intermediate element. This is not limited herein.

Still with reference to FIG. 8 and FIG. 14, optionally, the second swing arm 15 is fastened to a rotating shaft member 23, and the rotating shaft member 23 rotatably cooperates with the base 11. In this way, the second swing arm 15 can rotate relative to the base 11 around the rotating shaft member 23. In another embodiment, the rotatable cooperation between the second swing arm 15 and the base 11 may be alternatively implemented in another manner, for example, implemented by using the similar cooperation between the foregoing arc-shaped slider and the foregoing arc-shaped slot. This is not limited herein.

With reference to FIG. 8 and FIG. 15, in this embodiment, a positioning hole 24 is provided on a side that is of the connection portion 18 and that faces the door plate 151, a positioning boss 25 corresponding to the positioning hole 24 is provided on the door plate assembly 150, and the positioning boss 25 is positioned in and connected to the positioning hole 24, so that the door plate assembly 150 is positioned in and connected to the movable member 16. Optionally, the positioning hole 24 is a cylindrical hole, and the corresponding positioning boss 25 is also cylindrical. In some embodiments, there are two or more swing portions 12 on each side of the base 11. In this way, the door plate 151 on each side of the door plate assembly 150 is provided with a plurality of positioning bosses 25 distributed in a length direction, and the plurality of positioning bosses 25 are separately positioned in and connected to the movable members 16 of the plurality of swing portions 12 on the same side, thereby improving support reliability of the door plate 151. A connection manner of the door plate 151 and the connection portion 18 may be clipping, bonding, or a screw connection. A connection position between the door plate 151 and the connection portion 18 may also be set according to a requirement. For example, the door plate 151 is fastened to the positioning boss 25 by using a screw.

FIG. 17 and FIG. 18 each show a hinge assembly 80 according to another embodiment of this application. On the basis of the foregoing hinge assembly 10, the hinge assembly 80 further includes a damping assembly 26 and a synchronization assembly 27. The synchronization assembly 27 is configured to implement synchronous swing of swing portions 12 on two sides of a base 11. The damping assembly 26 is configured to increase damping performance of the swing portions 12 during swing. It should be noted that, to cooperate with the damping assembly 26, a second swing arm 15a of the hinge assembly 80 has a further structural design relative to the second swing arm 15 of the hinge assembly 10. A rotating shaft member 23a of the hinge assembly 80 is also designed differently from the rotating shaft member 23 of the hinge assembly 10.

With reference to FIG. 17 and FIG. 18, the hinge assembly 80 includes two rotating shaft members 23a. The two rotating shaft members 23a are spaced and connected to the base 11 in parallel. Central axes of the two rotating shaft members 23a and central axes of arc-shaped sliding slots C4 are spaced in parallel. Second swing arms 15a on the two sides are rotatably connected to the base 11 respectively by using the two rotating shaft members 23a. Optionally, the rotating shaft member 23a is rotatably connected to the base 11, and the second swing arm 15a is fastened to the rotating shaft member 23a, so that the second swing arm 15a can drive the rotating shaft member 23a to rotate relative to the base 11. The other end of the second swing arm 15a also slidably cooperates with the connection block 14.

The synchronization assembly 27 includes two intermediate gears 29 and two side gears 30. The two side gears 30 are respectively fixedly disposed on the two rotating shaft members 23a. The two intermediate gears 29 are respectively rotatably connected to the base 11 and are respectively engaged with the two side gears 30. The two intermediate gears 29 are engaged with each other. In this way, rotation of any one of the rotating shaft members 23a can drive, by using the two intermediate gears 29, the other rotating shaft member 23a to synchronously rotate. In this way, when a body 130 is folded and rotates, the second swing arm 15a drives the rotating shaft member 23a on this side, and further drives, to rotate, the rotating shaft member 23a on the other side through engagement of the two intermediate gears 29 and the two side gears 30. Therefore, the second swing arm 15a on the other side rotates, and the entire swing portion 12 on the other side is even driven to rotate synchronously.

The second swing arm 15a includes a plate portion 31 and two sleeve portions 32. The two sleeve portions 32 are spaced and connected to the plate portion 31. The plate portion 31 slidably cooperates with the connection block 14. The two sleeve portions 32 separately sleeved on the rotating shaft member 23a.

The damping assembly 26 includes two damping springs 33 and two damping blocks 34. The damping block 34 is provided with two cooperating holes K1 and is slidably sleeved on two rotating shaft members 23a by using the two cooperating holes K1. The two damping blocks 34 are spaced and located between the two sleeve portions 32. The damping springs 33 are respectively supported between the two damping blocks 34 and make the two damping blocks 34 respectively elastically abut against the two sleeve portions 32. In this way, the sleeve portions 32 cooperate with the damping blocks 34 in a damping manner. The damping cooperation between the damping block 34 and the sleeve portion 32 may be implemented through friction between contact surfaces, or profile cooperation is formed between opposite surfaces of the sleeve portion 32 and the damping block 34 to implement the damping cooperation with relative rotation. This is not limited herein.

In the hinge assembly 80 shown in FIG. 17 and FIG. 18, the rotating shaft member 23a serves as a rotating shaft of the second swing arm 15a. In addition, by using a structural design of the second swing arm 15a, the second swing arm 15a rotates and drives the rotating shaft member 23a to rotate. Through transmission of the gears, the swing portions 12 on the two sides are synchronized. By using the damping spring 33 and the damping block 34, damping effect with rotation is implemented. High structural integration is implemented, and effect of a damping function and a synchronization function can be reliably implemented. The second swing arm 15a and the rotating shaft member 23a may transmit torque through the profile cooperation. For example, a non-circular cross section is disposed on the rotating shaft member 23a, and a hole with a non-circular cross section is disposed on the sleeve portion 32 of the second swing arm 15a, to implement torque transmission.

In another embodiment, the foregoing damping assembly 26 may be disposed in another manner, for example, implemented by using friction between the rotating shaft member 23a and the second swing arm 15a. The damping assembly 26 may be not integrated into the hinge assembly 80, but disposed in another position of the foldable device 100. This is not limited herein. The damping assembly 26 may be alternatively omitted for some foldable devices 100 or hinge assemblies that do not need damping effect.

In another embodiment, the foregoing synchronization assembly 27 may be disposed in another manner, for example, by using a linkage mechanism. This is not limited herein.

With reference to FIG. 19 or FIG. 20, in another embodiment, the door plate assembly 150a/150b includes a flexible support plate 35, and the flexible support plate 35 is bridged between the movable members 16 on the two sides of the base 11. The door plate assembly 150 uses the flexible support plate 35 of an integrated structure, so that the flexible screen 110 can be supported in a larger area, thereby implementing better support effect.

As shown in FIG. 19, the flexible support plate 35 of the door plate assembly 150a is a solid plate made of an elastic material (for example, a nickel-titanium alloy plate), to adapt to the flexible screen 110 through deformation under force based on deformability of the material of the flexible support plate 35.

As shown in FIG. 20, the flexible support plate 35 of the door plate assembly 150b includes an intermediate plate region 36 and side plate regions 37 respectively connected to two sides of the intermediate plate region 36. The two side plate regions 37 are respectively connected to the movable members 16 on the two sides of the base 11. The intermediate plate region 36 is disposed in a hollow shape or with a reduced thickness, so that the intermediate plate region 36 can be bent and deformed under force. In this implementation, a hollow structure or a thicknessreduced structure is used to provide or assist in providing flexibility, and an elastic material or a relatively rigid material may be used in the structure. This is not limited herein.

According to the foregoing description, the hinge assembly 10/80 and the foldable device 100 in embodiments of this application can be used to conveniently implement different designs of the rotation angle of the door plate assembly 150/150a/150b. This has a simple structure, thereby facilitating support for the flexible screen 110.

The foregoing implementations are merely intended for describing the technical solutions of this application but not for limiting this application. The invention is defined by the appended claims.

## Claims

1. A hinge assembly (10) for a foldable device (100), wherein the hinge assembly comprises a base (11) and a plurality of swing portions (12), the plurality of swing portions are distributed on two sides of the base, and the swing portion comprises:
a first swing arm (13), wherein one end of the first swing arm is rotatably connected to the base, and the other end of the first swing arm is provided with a pin portion (17) and a first arc-shaped slot;
a connection block (14), wherein the connection block is provided with a strip slot, the pin portion cooperates with the strip slot and can slide along a length direction (Y2) of the strip slot and rotate relative to the connection block in the strip slot, and the connection block is further provided with a second arc-shaped slot (C2);
a second swing arm (15), wherein one end of the second swing arm is rotatably connected to the base, and the other end of the second swing arm slidably cooperates with the connection block; and
a movable member (16), wherein one end of the movable member slidably cooperates with the first arc-shaped slot, so that the movable member can rotate about a circle center of the first arc-shaped slot relative to the first swing arm; the other end of the movable member slidably cooperates with the second arc-shaped slot, so that the connection block can rotate about a circle center of the second arc-shaped slot relative to the movable member; and the movable member is further provided with a connection portion (18) configured to connect to a door plate assembly (150, 150a, 150b);
wherein a side that is of the connection block and that is near the base is provided with a concave cut slot (C7), there are two strip slots (C3), and the two strip slots are respectively located on two side slot surfaces of the cut slot; and there are two pin portions, the two pin portions are respectively located on two sides of the first swing arm, and the two pin portions are respectively inserted into the two strip slots;
wherein an edge line of the side that is of the connection block and that is near the base is a first edge (L1), and an edge line of a side that is of the connection block and that is away from the base is a second edge (L2); and an extension axis of the pin portion is parallel to a rotation axis of the first swing arm relative to the base, and the pin portion is located between the first edge and the second edge;
wherein the connection block has a cooperating portion (21) located between the second edge and a slot bottom surface of the cut slot, and the second arc-shaped slot is provided on the cooperating portion; and the movable member is provided with a second arc-shaped slider (28), the second arc-shaped slider is connected to an end that is of the connection portion and that is away from the base, and the second arc-shaped slider slidably cooperates with the second arc-shaped slot;
wherein the cooperating portion is provided with a groove concave (C8) in a thickness direction of the connection block, there are two second arc-shaped slots, and the two second arc-shaped slots are respectively disposed on two side groove surfaces of the groove; and there are two second arc-shaped sliders, the two second arc-shaped sliders are respectively connected to two sides of the end that is of the connection portion and that is away from the base, the connection portion is at least partially embedded in the groove, and the two second arc-shaped sliders respectively slidably cooperate with the two second arc-shaped slots; and
wherein the thickness direction of the connection block is a thickness direction of the foldable device.

2. The hinge assembly according to claim 1, wherein
an edge line of a side that is of the first swing arm and that is away from the base is a third edge (L3), the first swing arm is provided with a notched groove (C5) recessed from a middle position of the third edge, there are two first arc-shaped slots (C1), and the two first arc-shaped slots are respectively provided on two side groove surfaces of the notched groove; and
the movable member comprises two first arc-shaped sliders (20), the two first arc-shaped sliders are respectively connected to ends of two sides that are of the connection portion and that are near the base, the connection portion is at least partially embedded in the notched groove, and the two first arc-shaped sliders respectively slidably cooperate with the two first arc-shaped slots.

3. The hinge assembly according to claim 2, wherein
an opening of the notched groove is opposite to an opening of the groove, and the notched groove and the groove jointly form space for accommodating the connection portion.

4. The hinge assembly according to claim 2, wherein
an end that is of the first swing arm and that is away from the base has two extended sections (22) that are respectively located on two sides of the notched groove, and the two pin portions respectively protrude from outer side surfaces of the two extended sections; and
at least one side slot surface of the cut slot is inclined outwards at an opening of the cut slot to form a guide slope (P3) that is configured to guide the pin portion to be clipped into the strip slot.

5. The hinge assembly according to claim 1, wherein
lugs (38) protruding from surfaces of the connection block in a thickness direction are respectively disposed on the two side slot surfaces of the cut slot, and the strip slots are provided on the lugs.

6. The hinge assembly according to claim 1, wherein
the connection block is provided with a sliding slot (C6), and the sliding slot is at a middle position in a thickness direction of the connection block; and
the second swing arm is slidably inserted into the sliding slot.

7. The hinge assembly according to claim 1, wherein
a positioning hole (24) is provided on a side that is of the connection portion and that faces the door plate, configured for positioning a positioning boss (25) of the door plate for the door plate assembly being positioned in and connected to the movable member.

8. The hinge assembly according to claim 1, wherein
arc-shaped sliding slots (C4) are respectively provided on the two sides of the base, first swing arms in the swing portions on the two sides of the base are respectively provided with arc-shaped sliding bolts (19) slidably cooperating with the arc-shaped sliding slots, and the arc-shaped sliding bolts slidably cooperate with the arc-shaped sliding slots, so that the first swing arm can rotate around a central axis of the arc-shaped sliding slot.

9. The hinge assembly according to claim 8, wherein
the hinge assembly comprises two rotating shaft members (23), the two rotating shaft members are spaced and connected to the base in parallel, and central axes of the two rotating shaft members and central axes of the arc-shaped sliding slots are spaced in parallel; and
second swing arms in the swing portions on the two sides of the base are rotatably connected to the base respectively by using the two rotating shaft members.

10. The hinge assembly according to claim 9, wherein
the rotating shaft member is rotatably connected to the base, and the second swing arm is fastened to the rotating shaft member, so that the second swing arm can drive the rotating shaft member to rotate relative to the base; and
the hinge assembly further comprises a synchronization assembly (27), the synchronization assembly comprises two intermediate gears (29) and two side gears (30), the two side gears are respectively fixedly disposed on the two rotating shaft members, the two intermediate gears are respectively rotatably connected to the base and are respectively engaged with the two side gears, and the two intermediate gears are engaged with each other, so that rotation of any one of the rotating shaft members can drive, by using the two intermediate gears, the other rotating shaft member to synchronously rotate.

11. A foldable device (100), comprising:
the hinge assembly according to any one of claims 1 to 10;
two bodies (130, 130a, 130b), wherein the two bodies are respectively located on two sides of the base, and the two bodies are respectively connected to connection blocks of swing portions on the two sides;
a door plate assembly (150, 150a, 150b), wherein the door plate assembly is connected to the movable members on the two sides of the base; and
a flexible screen (110), wherein the flexible screen covers the two bodies, the flexible screen has a bendable part (111), and the bendable part is supported on the door plate assembly.

## Patentansprüche

1. Scharnieranordnung (10) für eine faltbare Vorrichtung (100), wobei die Scharnieranordnung eine Basis (11) und eine Vielzahl von Schwenkabschnitten (12) umfasst, wobei die Vielzahl von Schwenkabschnitten auf zwei Seiten der Basis verteilt ist und der Schwenkabschnitt Folgendes umfasst:
einen ersten Schwenkarm (13), wobei ein Ende des ersten Schwenkarms drehbar mit der Basis verbunden ist und das andere Ende des ersten Schwenkarms mit einem Stiftabschnitt (17) und einem ersten bogenförmigen Schlitz versehen ist;
einen Verbindungsblock (14), wobei der Verbindungsblock mit einem Langloch versehen ist, der Stiftabschnitt mit dem Langloch zusammenwirkt und entlang einer Längsrichtung (Y2) des Langlochs gleiten sowie relativ zu dem Verbindungsblock in dem Langloch rotieren kann, und wobei der Verbindungsblock ferner mit einem zweiten bogenförmigen Schlitz (C2) versehen ist;
einen zweiten Schwenkarm (15), wobei ein Ende des zweiten Schwenkarms drehbar mit der Basis verbunden ist und das andere Ende des zweiten Schwenkarms gleitend mit dem Verbindungsblock zusammenwirkt; und
ein bewegliches Element (16), wobei ein Ende des beweglichen Elements gleitend mit dem ersten bogenförmigen Schlitz zusammenwirkt, sodass das bewegliche Element relativ zu dem ersten Schwenkarm um einen Kreismittelpunkt des ersten bogenförmigen Schlitzes rotieren kann; wobei das andere Ende des beweglichen Elements gleitend mit dem zweiten bogenförmigen Schlitz zusammenwirkt, sodass der Verbindungsblock relativ zu dem beweglichen Element um einen Kreismittelpunkt des zweiten bogenförmigen Schlitzes rotieren kann; und wobei das bewegliche Element ferner mit einem Verbindungsabschnitt (18) versehen ist, der dazu konfiguriert ist, eine Verbindung zu einer Türplattenanordnung (150, 150a, 150b) herzustellen;
wobei eine Seite des Verbindungsblocks, die sich nahe der Basis befindet, mit einem konkaven Einschnitt (C7) versehen ist, wobei zwei Langlöcher (C3) vorhanden sind und die beiden Langlöcher jeweils an zwei Seitenschlitzflächen des Einschnitts angeordnet sind; und wobei zwei Stiftabschnitte vorhanden sind, wobei die beiden Stiftabschnitte jeweils an zwei Seiten des ersten Schwenkarms angeordnet sind und die beiden Stiftabschnitte jeweils in die beiden Langlöcher eingefügt sind;
wobei eine Kantenlinie der Seite des Verbindungsblocks, die sich nahe der Basis befindet, eine erste Kante (L1) ist, und eine Kantenlinie einer Seite des Verbindungsblocks, die von der Basis entfernt ist, eine zweite Kante (L2) ist; und wobei eine Erstreckungsachse des Stiftabschnitts parallel zu einer Rotationsachse des ersten Schwenkarms relativ zur Basis verläuft und der Stiftabschnitt zwischen der ersten Kante und der zweiten Kante angeordnet ist;
wobei der Verbindungsblock einen zusammenwirkenden Abschnitt (21) aufweist, der zwischen der zweiten Kante und einer Schlitzbodenfläche des Einschnitts angeordnet ist, und der zweite bogenförmigen Schlitz an dem zusammenwirkenden Abschnitt vorgesehen ist; und wobei das bewegliche Element mit einem zweiten bogenförmigen Gleiter (28) versehen ist, wobei der zweite bogenförmige Gleiter mit einem Ende des Verbindungsabschnitts verbunden ist, das von der Basis entfernt ist, und wobei der zweite bogenförmige Gleiter gleitend mit dem zweiten bogenförmigen Schlitz zusammenwirkt;
wobei der zusammenwirkende Abschnitt mit einer Vertiefung (C8) in einer Dickenrichtung des Verbindungsblocks versehen ist, wobei zwei zweite bogenförmige Schlitze vorhanden sind und die zwei zweiten bogenförmigen Schlitze jeweils an zwei Seitennutflächen der Vertiefung angeordnet sind; und wobei zwei zweite bogenförmige Gleiter vorhanden sind, wobei die zwei zweiten bogenförmigen Gleiter jeweils mit zwei Seiten des Endes des Verbindungsabschnitts verbunden sind, das von der Basis entfernt ist, wobei der Verbindungsabschnitt zumindest teilweise in die Vertiefung eingebettet ist und die zwei zweiten bogenförmigen Gleiter jeweils gleitend mit den zwei zweiten bogenförmigen Schlitzen zusammenwirken; und
wobei die Dickenrichtung des Verbindungsblocks eine Dickenrichtung der faltbaren Vorrichtung ist.

2. Scharnieranordnung nach Anspruch 1, wobei
eine Kantenlinie einer Seite des ersten Schwenkarms, die von der Basis entfernt ist, eine dritte Kante (L3) ist, wobei der erste Schwenkarm mit einer eingekerbten Nut (C5) versehen ist, die von einer mittleren Position der dritten Kante zurückgesetzt ist, wobei zwei erste bogenförmige Schlitze (C1) vorhanden sind und die zwei ersten bogenförmigen Schlitze jeweils an zwei Seitennutflächen der eingekerbten Nut vorgesehen sind; und
das bewegliche Element zwei erste bogenförmige Gleiter (20) umfasst, wobei die zwei ersten bogenförmigen Gleiter jeweils mit Enden von zwei Seiten des Verbindungsabschnitts verbunden sind, die nahe der Basis liegen, wobei der Verbindungsabschnitt zumindest teilweise in die eingekerbte Nut eingebettet ist und die zwei ersten bogenförmigen Gleiter jeweils gleitend mit den zwei ersten bogenförmigen Schlitzen zusammenwirken.

3. Scharnieranordnung nach Anspruch 2, wobei
eine Öffnung der eingekerbten Nut einer Öffnung der Vertiefung gegenüberliegt und die eingekerbte Nut sowie die Vertiefung gemeinsam einen Raum zur Aufnahme des Verbindungsabschnitts bilden.

4. Scharnieranordnung nach Anspruch 2, wobei
ein Ende des ersten Schwenkarms, das von der Basis entfernt ist, zwei verlängerte Abschnitte (22) aufweist, die jeweils an zwei Seiten der eingekerbten Nut angeordnet sind, und die zwei Stiftabschnitte jeweils von äußeren Seitenflächen der zwei verlängerten Abschnitte hervorstehen; und
mindestens eine seitliche Schlitzoberfläche des Einschnitts an einer Öffnung des Einschnitts nach außen geneigt ist, um eine Führungsschräge (P3) zu bilden, die so konfiguriert ist, dass sie den Stiftabschnitt führt, damit dieser in das Langloch aufgenommen wird.

5. Scharnieranordnung nach Anspruch 1, wobei
Vorsprünge (38), die in einer Dickenrichtung von Oberflächen des Verbindungsblocks hervorstehen, jeweils an den beiden seitlichen Schlitzoberflächen des Einschnitts angeordnet sind und die Langlöcher an den Vorsprüngen vorgesehen sind.

6. Scharnieranordnung nach Anspruch 1, wobei
der Verbindungsblock mit einem Gleitschlitz (C6) versehen ist und der Gleitschlitz sich an einer mittleren Position in einer Dickenrichtung des Verbindungsblocks befindet; und
der zweite Schwenkarm verschiebbar in den Gleitschlitz eingesetzt ist.

7. Scharnieranordnung nach Anspruch 1, wobei
ein Positionierungsloch (24) an einer Seite des Verbindungsabschnitts vorgesehen ist, die der Türplatte zugewandt ist, konfiguriert zum Positionieren eines Positionierungsvorsprungs (25) der Türplatte, damit die Türplattenbaugruppe in dem beweglichen Element positioniert und mit diesem verbunden werden kann.

8. Scharnieranordnung nach Anspruch 1, wobei
bogenförmige Gleitschlitze (C4) jeweils an den beiden Seiten der Basis vorgesehen sind, erste Schwenkarme in den Schwenkabschnitten an den beiden Seiten der Basis jeweils mit bogenförmigen Gleitbolzen (19) versehen sind, die verschiebbar mit den bogenförmigen Gleitschlitzen zusammenwirken, und die bogenförmigen Gleitbolzen verschiebbar mit den bogenförmigen Gleitschlitzen zusammenwirken, sodass der erste Schwenkarm um eine Mittelachse des bogenförmigen Gleitschlitzes rotieren kann.

9. Scharnieranordnung nach Anspruch 8, wobei
die Scharnieranordnung zwei Drehwellenelemente (23) umfasst, die beiden Drehwellenelemente beabstandet und parallel mit der Basis verbunden sind und Mittelachsen der beiden Drehwellenelemente und Mittelachsen der bogenförmigen Gleitschlitze parallel beabstandet sind; und
zweite Schwenkarme in den Schwenkabschnitten an den beiden Seiten der Basis jeweils unter Verwendung der beiden Drehwellenelemente drehbar mit der Basis verbunden sind.

10. Scharnieranordnung nach Anspruch 9, wobei
das Drehwellenelement drehbar mit der Basis verbunden ist und der zweite Schwenkarm an dem Drehwellenelement befestigt ist, sodass der zweite Schwenkarm das Drehwellenelement dazu antreiben kann, relativ zur Basis zu rotieren; und
die Scharnieranordnung ferner eine Synchronisationsanordnung (27) umfasst, wobei die Synchronisationsanordnung zwei Zwischenzahnräder (29) und zwei Seitenräder (30) umfasst, wobei die beiden Seitenräder jeweils fest an den beiden Drehwellenelementen angeordnet sind, die beiden Zwischenzahnräder jeweils drehbar mit der Basis verbunden sind und jeweils mit den beiden Seitenrädern in Eingriff stehen, und die beiden Zwischenzahnräder miteinander in Eingriff stehen, sodass eine Drehung eines beliebigen der Drehwellenelemente über die beiden Zwischenzahnräder das andere Drehwellenelement zu einer synchronen Drehung antreiben kann.

11. Faltbare Vorrichtung (100), umfassend:
die Scharnieranordnung nach einem der Ansprüche 1 bis 10;
zwei Körper (130, 130a, 130b), wobei die zwei Körper jeweils auf zwei Seiten der Basis angeordnet sind und die zwei Körper jeweils mit Verbindungsblöcken von Schwenkabschnitten auf den beiden Seiten verbunden sind;
eine Türplattenanordnung (150, 150a, 150b), wobei die Türplattenanordnung mit den beweglichen Elementen auf den beiden Seiten der Basis verbunden ist; und
einen flexiblen Bildschirm (110), wobei der flexible Bildschirm die zwei Körper bedeckt, der flexible Bildschirm einen biegbaren Teil (111) aufweist und der biegbare Teil auf der Türplattenanordnung abgestützt ist.

## Revendications

1. Ensemble charnière (10) pour un dispositif pliable (100), dans lequel l'ensemble charnière comprend une base (11) et une pluralité de parties oscillantes (12), la pluralité de parties oscillantes sont réparties sur deux côtés de la base, et la partie oscillante comprend :
un premier bras oscillant (13), dans lequel une extrémité du premier bras oscillant est reliée de manière rotative à la base, et l'autre extrémité du premier bras oscillant est pourvue d'une partie goupille (17) et d'une première fente en forme d'arc ;
un bloc de connexion (14), dans lequel le bloc de connexion est pourvu d'une fente oblongue, la partie goupille coopère avec la fente oblongue et peut coulisser le long d'une direction de longueur (Y2) de la fente oblongue et tourner par rapport au bloc de connexion dans la fente oblongue, et le bloc de connexion est en outre pourvu d'une seconde fente en forme d'arc (C2) ;
un second bras oscillant (15), dans lequel une extrémité du second bras oscillant est reliée de manière rotative à la base, et l'autre extrémité du second bras oscillant coopère de manière coulissante avec le bloc de connexion ; et
un élément mobile (16), dans lequel une extrémité de l'élément mobile coopère de manière coulissante avec la première fente en forme d'arc, de sorte que l'élément mobile puisse tourner autour d'un centre de cercle de la première fente en forme d'arc par rapport au premier bras oscillant ; l'autre extrémité de l'élément mobile coopère de manière coulissante avec la seconde fente en forme d'arc, de sorte que le bloc de connexion puisse tourner autour d'un centre de cercle de la seconde fente en forme d'arc par rapport à l'élément mobile ; et l'élément mobile est en outre pourvu d'une partie de liaison (18) configurée pour se connecter à un ensemble panneau de porte (150, 150a, 150b) ;
dans lequel un côté qui est celui du bloc de connexion et qui est proche de la base est pourvu d'une encoche concave (C7), deux fentes oblongues (C3) sont prévues, et les deux fentes oblongues sont situées respectivement sur deux surfaces latérales de fente de l'encoche ; et deux parties goupille sont prévues, les deux parties goupille sont situées respectivement sur deux côtés du premier bras oscillant, et les deux parties goupille sont insérées respectivement dans les deux fentes oblongues ;
dans lequel une ligne de bord du côté qui est celui du bloc de connexion et qui est proche de la base est un premier bord (L1), et une ligne de bord d'un côté qui est celui du bloc de connexion et qui est éloigné de la base est un second bord (L2) ; et un axe d'extension de la partie goupille est parallèle à un axe de rotation du premier bras oscillant par rapport à la base, et la partie goupille est située entre le premier bord et le second bord ;
dans lequel le bloc de connexion comporte une partie coopérante (21) située entre le second bord et une surface de fond de fente de l'encoche, et la seconde fente en forme d'arc est prévue sur la partie coopérante ; et l'élément mobile est pourvu d'un second curseur en forme d'arc (28), le second curseur en forme d'arc est relié à une extrémité qui est de la partie de connexion et qui est éloignée de la base, et le second curseur en forme d'arc coopère de manière coulissante avec la seconde fente en forme d'arc ;
dans lequel la partie coopérante est pourvue d'une rainure concave (C8) dans une direction d'épaisseur du bloc de connexion, il existe deux secondes fentes en forme d'arc, et les deux secondes fentes en forme d'arc sont disposées respectivement sur deux surfaces latérales de rainure de la rainure ; et il existe deux seconds curseurs en forme d'arc, les deux seconds curseurs en forme d'arc sont respectivement reliés à deux côtés de l'extrémité qui est de la partie de connexion et qui est éloignée de la base, la partie de connexion est au moins partiellement encastrée dans la rainure, et les deux seconds curseurs en forme d'arc coopèrent respectivement de manière coulissante avec les deux secondes fentes en forme d'arc ; et
dans lequel la direction d'épaisseur du bloc de connexion est une direction d'épaisseur du dispositif pliable.

2. L'ensemble charnière selon la revendication 1, dans lequel
une ligne de bord d'un côté qui est du premier bras oscillant et qui est éloigné de la base est un troisième bord (L3), le premier bras oscillant est pourvu d'une rainure entaillée (C5) évidée à partir d'une position médiane du troisième bord, il existe deux premières fentes en forme d'arc (C1), et les deux premières fentes en forme d'arc sont respectivement prévues sur deux surfaces latérales de rainure de la rainure entaillée ; et
l'élément mobile comprend deux premiers curseurs en forme d'arc (20), les deux premiers curseurs en forme d'arc sont respectivement reliés aux extrémités de deux côtés qui sont de la partie de connexion et qui sont proches de la base, la partie de connexion est au moins partiellement encastrée dans la rainure entaillée, et les deux premiers curseurs en forme d'arc coopèrent respectivement de manière coulissante avec les deux premières fentes en forme d'arc.

3. L'ensemble charnière selon la revendication 2, dans lequel
une ouverture de la rainure entaillée est opposée à une ouverture de la rainure, et la rainure entaillée et la rainure forment conjointement un espace destiné à loger la partie de connexion.

4. L'ensemble charnière selon la revendication 2, dans lequel
une extrémité qui est du premier bras oscillant et qui est éloignée de la base présente deux sections étendues (22) qui sont respectivement situées sur deux côtés de la rainure entaillée, et les deux parties de broche font respectivement saillie des surfaces latérales extérieures des deux sections étendues ; et
au moins une surface de fente latérale de l'encoche est inclinée vers l'extérieur au niveau d'une ouverture de l'encoche pour former une pente de guidage (P3) configurée pour guider la partie goupille à s'insérer dans la fente oblongue.

5. L'ensemble charnière selon la revendication 1, dans lequel
des ergots (38) faisant saillie à partir des surfaces du bloc de connexion dans une direction d'épaisseur sont disposés respectivement sur les deux surfaces de fente latérale de l'encoche, et les fentes oblongues sont prévues sur les ergots.

6. L'ensemble charnière selon la revendication 1, dans lequel
le bloc de connexion est pourvu d'une fente coulissante (C6), et la fente coulissante se trouve dans une position médiane dans une direction d'épaisseur du bloc de connexion ; et
le second bras oscillant est inséré de manière coulissante dans la fente coulissante.

7. L'ensemble charnière selon la revendication 1, dans lequel
un trou de positionnement (24) est prévu sur un côté qui appartient à la partie de connexion et qui fait face à la plaque de porte, configuré pour positionner un bossage de positionnement (25) de la plaque de porte pour que l'ensemble de plaque de porte soit positionné dans et connecté à l'élément mobile.

8. L'ensemble charnière selon la revendication 1, dans lequel
des fentes coulissantes en forme d'arc (C4) sont respectivement prévues sur les deux côtés de la base, des premiers bras oscillants dans les parties oscillantes sur les deux côtés de la base sont respectivement pourvus de boulons coulissants en forme d'arc (19) coopérant de manière coulissante avec les fentes coulissantes en forme d'arc, et les boulons coulissants en forme d'arc coopèrent de manière coulissante avec les fentes coulissantes en forme d'arc, de sorte que le premier bras oscillant peut tourner autour d'un axe central de la fente coulissante en forme d'arc.

9. L'ensemble charnière selon la revendication 8, dans lequel
l'ensemble charnière comprend deux éléments d'arbre rotatif (23), les deux éléments d'arbre rotatif sont espacés et connectés à la base en parallèle, et les axes centraux des deux éléments d'arbre rotatif et les axes centraux des fentes coulissantes en forme d'arc sont espacés en parallèle ; et
les seconds bras oscillants dans les parties oscillantes sur les deux côtés de la base sont connectés de manière rotative à la base respectivement en utilisant les deux éléments d'arbre rotatif.

10. L'ensemble charnière selon la revendication 9, dans lequel
l'élément d'arbre rotatif est connecté de manière rotative à la base, et le second bras oscillant est fixé à l'élément d'arbre rotatif, de sorte que le second bras oscillant peut entraîner l'élément d'arbre rotatif à tourner par rapport à la base ; et
l'ensemble charnière comprend en outre un ensemble de synchronisation (27), l'ensemble de synchronisation comprend deux engrenages intermédiaires (29) et deux pignons latéraux (30), les deux pignons latéraux sont fixés respectivement sur les deux éléments d'arbre rotatif, les deux engrenages intermédiaires sont reliés de manière rotative à la base et sont respectivement en prise avec les deux pignons latéraux, et les deux engrenages intermédiaires sont en prise l'un avec l'autre, de sorte que la rotation de l'un quelconque des éléments d'arbre rotatif peut entraîner, par l'utilisation des deux engrenages intermédiaires, l'autre élément d'arbre rotatif à tourner de manière synchrone.

11. Un dispositif pliable (100), comprenant :
l'ensemble charnière selon l'une quelconque des revendications 1 à 10 ;
deux corps (130, 130a, 130b), dans lequel les deux corps sont situés respectivement sur deux côtés de la base, et les deux corps sont reliés respectivement aux blocs de connexion des parties oscillantes sur les deux côtés ;
un ensemble plaque de porte (150, 150a, 150b), dans lequel l'ensemble plaque de porte est relié aux éléments mobiles sur les deux côtés de la base ; et
un écran flexible (110), dans lequel l'écran flexible recouvre les deux corps, l'écran flexible a une partie pliable (111), et la partie pliable est supportée sur l'ensemble plaque de porte.
